# EUROPÄISCHE PATENTSCHRIFT

(11) **EP 1 849 586 B1**
(45) Veröffentlichungstag und Bekanntmachung des Hinweises auf die Patenterteilung: **23.09.2015**
(21) Anmeldenummer: 07004773.3
(22) Anmeldetag: 08.03.2007
(51) Int. Cl.: B29C 67/00, G03F 7/20, G03F 7/00, B33Y 10/00, B33Y 30/00, B29C 35/08

(54) **Vorrichtung und Verfahren zur Herstellung eines dreidimensionalen Objekts mittels Maskenbelichtung**
Device and method for creating a three dimensional object using mask illumination
Dispositif et procédé destinés à la fabrication d'un objet tridimensionnel pour lesquels l'éclairage est réalisé à travers des masques

(30) Priorität: 28.04.2006 DE 102006019964; 28.04.2006 US 796160 P
(43) Veröffentlichungstag der Anmeldung: 31.10.2007
(73) Patentinhaber: Envisiontec GmbH, 45968 Gladbeck (DE)
(72) Erfinder: John, Hendrik, 46569 Hünxe (DE); Schillen, Volker, Dr., 40629 Düsseldorf (DE); El-Siblani, Ali, Dearborn Heights, MI 48127 (US)
(74) Vertreter: Oser, Andreas

(56) Entgegenhaltungen:
- WO-A-2005/110722
- DE-A1- 19 929 199
- FR-A- 2 692 053
- US-A- 5 263 130

## Beschreibung

### Anwendungsgebiet

Die Erfindung betrifft eine Vorrichtung und ein Verfahren zur Herstellung eines dreidimensionalen Objektes durch Verfestigen eines verfestigbaren Materials unter Einwirkung von elektromagnetischer Strahlung mittels Energieeintrag über eine bildgebende Einheit, die eine bestimmte Anzahl diskreter bildgebender Elemente (Pixel) aufweist. Insbesondere betrifft diese Erfindung Vorrichtungen und Verfahren, bei denen die Verfestigung des Materials durch Belichtung mittels einer gerasterten Maske beruht, wobei die kleinste physikalische Auflösung in der Maske durch die Größe eines Pixels gegeben ist und für die bildgebende Einheit zum Beispiel die Spacial Light Modulator (SLM) Technologie eingesetzt wird.

### Stand der Technik

Für den Aufbau dreidimensionaler Objekte aus ,,lichthärtenden" Photopolymeren werden in der Literatur unterschiedlichste Verfahren angegeben, siehe hierzu ,,Automated Fabrication - Improving Productivity in Manufacturing" von Marshall Burns, 1993 (ISBN 0-13-119462-3).

Bekannte Möglichkeiten sind u.a. die Belichtung durch
a) Multimedia Projektor
b) LC-Display (refelxiv, transmissiv)
c) LED-, bzw. Laser-Dioden-Zeile (die orthogonal zur Zeile über die Fläche bewegt wird)
d) Lichtventil-Technologie (MEMS)

Diese Methoden werden in folgenden Patenten beschrieben:
US-Patent US005247180A "Stereolithographic Apparatus and Method of use" von Texas Instruments Inc., Sept. 1993.
US-Patent US005980813A ,,Rapid Prototyping using multiple materials" von SRI International, Nov. 1999;
Gebrauchsmusterschrift DE G 93 19 405.6 ,,Vorrichtung zur Herstellung eines dreidimensionalen Objekts (Modells) nach dem Prinzip der Photoverfestigung" vom Forschungszentrum Informatik an der Universität Karlsruhe, Dez. 1993;
Eine Anwendung für die Erzeugung mikrotechnischer, dreidimensionaler Bauteile nach einem ähnlichen Verfahren wird in der Gebrauchsmusterschrift DE 299 11 122 U1 "Vorrichtung zum Herstellen eines dreidimensionalen Objektes", DeltaMed u.a., Juni 1999, beschrieben.
EP 1250997A (= US2002155189A) "Vorrichtung zum Herstellen eines dreidimensionalen Objektes" der Envision Technologies GmbH, April 2002.
Deutsches Patent DE69909136T ,,Rapid-Prototyping-vorrichtung und Rapid-Prototyping-Methode", Juli 2003 (Equivalent: Europäisches Patent EP 1156922 ,,Rapid Prototyping Apparatus and Method of Rapid Prototyping", August 2003) der DICON AS Lystrup, Dänemark.
WO 01/00390 A von HAP, Sitec Industrietechnologie und DELTAMED Medizinprodukte GmbH.
WO 2005/110722 A der Envisiontec GmbH.

Bei Laser-basierten Systemen zur Photopolymerisation wird die Lichtleistung im Belichtungspunkt durch die Energieeinstellung des Laserstrahls vorgenommen, wodurch die Durchhärtetiefe des Photopolymers in diesem Punkt gesteuert werden kann.
Um eine entsprechende Schicht selektiv auszuhärten, wird der Laserstrahl über die entsprechend auszuhärtende Querschnittsfläche gescannt.
Die Konturen der auszuhärtenden Querschnittsfläche können vom Laserstrahl als Kurve abgefahren werden.

Das US-Patent 5,263,130 beschreibt ein System zur Herstellung eines dreidimensionalen Objekts durch Verfestigen eines verfestigbaren Materials, bei dem nach Belichtung des zu verfestigenden Materials der nichtbelichtete Bereich ersetzt wird durch Trägermaterial, um einer Materialschrumpfung infolge der Verfestigung vorzubeugen. Die Belichtung kann durch Einsatz einer Grafikbelichtungsmaske erfolgen. In einer Ausführungsform wird die Belichtung einer Fläche aufgeteilt durch Verwendung komplementärer Teilmasken, um einer noch stärkeren Schrumpfung bei Verfestigung von großen Flächen entgegenzuwirken.

US 5 263 130 offenbart eine Vorrichtung gemäß dem Oberbegriff des Anspruchs 1 und ein Verfahren gemäß dem Oberbegriff des Anspruchs 10.

Bei Systemen zur Photopolymerisation basierend auf Maskenprojektion mittels Projektionssystemen mit SLM-Technologie liegt der Vorteil darin, eine gesamte Querschnittsfläche auf einmal belichten zu können. Die hellen Bereiche des projezierten, gerasterten Bildes härten das Photopolymer Voxel für Voxel aus.

Der Nachteil bei Projektionssystemen mit SLM-Technologie ist, dass die Lichtleistungsverteilung über die Bildfläche sehr inhomogen sein kann (absolut bis zu 50%) in Abhängigkeit von
a) der verwendeten Lichtquelle,
b) dem optischen System zur Einkopplung der Lichtenergie auf den SLM und
c) durch die Vignetierung der Projektionsoptik.
Die Veränderung der Eigenschaften der Lichtquelle über die Lebensdauer führen zu einem variablen Fehler und somit zu einer sich verändernden Homogenitätsverteilung.
Ausserdem führt eine Veränderung der Lichtintensität der Lichtquelle nicht zu einer punktuellen Veränderung wie bei einem Laser, sondern würde das komplette Projektionsbild betreffen.

Bei Homogenitätsabweichungen hervorgerufen durch das optische System zur Einkopplung der Lichtenergie auf den SLM und die Projektionsoptik handelt es sich um einen konstanten Fehler.

Die Konturen der auszuhärtenden Querschnittsfläche können nur gerastert dargestellt werden; die Auflösung ist abhängig von der Anzahl der Bildpunkte / Pixel und der Größe des projizierten Bildes.

Außerdem variiert die Energie- bzw. Lichtintensität in Abhängigkeit von der Größe der bestrahlten Flächenstruktur (höhere Intensität bei größeren, zusammenhängenden Flächen, geringere Intensität bei kleinen, filigranen Flächenstrukturen)

Bei der oben genannten WO 01/00390 A wird die Intensität von Strahlen durch Steuerung der Durchlässigkeit der Maske gesteuert, wobei die Steuerung der Intensität über die Ansteuerung von Graustufen eines Transmissions-LCD erfolgen kann.
Bei der WO 2005/110722 A wird zur Verbesserung der Auflösung entlang der Außen- und Innenkonturen der Querschnittsflächen des zu generierenden Objektes im Subpixelbereich pro Schicht eine Mehrfachbelichtung vorgenommen, die aus einer Abfolge einer Mehrzahl von im Subpixelbereich versetzten Bildern in der Bild-/Bauebene besteht, wobei für jedes versetzte Bild eine separate Maske/Bitmap erzeugt wird.
Weder in der WO 01/00390 A noch in der WO 2005/110722 wird gezeigt, wie die Auflösung und die Feineinstellung in der Bildebene verbessert werden können und wie native Inhomogenitäten der Lichtquelle besser ausgeglichen werden können.

### Aufgabe der Erfindung

Aufgabe der Erfindung ist es, Vorrichtung und Verfahren zur Herstellung eines dreidimensionalen Objektes durch Verfestigen eines unter Einwirkung von elektromagnetischer Strahlung verfestigbaren Materials mittels Energieeintrag über eine bildgebende Einheit, die eine bestimmte Anzahl diskreter bildgebender Elemente (Pixel) aufweist, so zu verbessern, dass eine höhere Genauigkeit, höhere Auflösung und Feineinstellung und/oder eine höhere Homogenität des Systems erreicht wird.

### Lösung der Aufgabe

Diese Aufgabe wird durch eine Vorrichtung gemäß Anspruch 1 bzw. durch ein Verfahren gemäß Anspruch 10 gelöst. Bevorzugte Weiterbildungen der Vorrichtung und des Verfahrens gemäß der Erfindung sind in den Unteransprüchen festgelegt.

### Beschreibung der bevorzugten Ausführungsformen und der Vorteile der Erfindung

Vorrichtung und Verfahren gemäß der Erfindung erlauben es, die Inhomogenitäten in der Bildebene zu beseitigen und dadurch eine höhere Genauigkeit, höhere Auflösung und Feineinstellung zu erreichen.

Die Erfindung ermöglicht es, zum einen durch eine Energie- bzw. Lichtleistungssteuerung auf Pixel-Niveau die Durchärtetiefe eines Voxels im auszuhärtenden Material zu kontrollieren und zum anderen gezielt selektive Bereiche pro auszuhärtender Querschnittsfläche überbelichten zu können, ohne die Eigenschaften der bildgebenden Einheit inkl. Energie- bzw. Lichtquelle zu verändern, indem pro Bauebene / Belichtungszyklus wahlweise durch eine oder mehrere aufeinanderfolgende digitale Masken (Bitmaps) belichtet wird, wobei vorzugsweise ferner die WEISS/SCHWARZ-Rasterung (bzw. HELL/DUNKEL- und/oder FARB-Rasterung) innerhalb der Maske von Maske zu Maske unterschiedlich sein kann und/oder die Belichtungszeiten pro Maske variiert werden können.

Durch die Bestrahlung mittels einer gerasterten Maske wird in dem auszuhärtenden Material eine Matrix aus sogenannten Voxeln (Volumen-Pixeln) ausgehärtet, wobei die XY-Rasterung durch die Größe, Anzahl und Anordung der Pixel vorgegeben ist und die Höhe (=Durchhärtetiefe) der Voxel im Material durch die Mehrfachbelichtung gesteuert werden kann. In bevorzugten Ausführungsformen kann ferner die Intensität und/oder das Spektrum der Bestrahlung, speziell über den Grauwert und/oder den Farbwert (letzteres durch die Wellenlänge oder den Wellenlängenbereich der elektromagnetischen Strahlung) pro Pixel gesteuert werden.

Erfindungsgemäß können je nach Anforderung spezielle Bereiche der zu generierenden Struktur , d.h. nur innerhalb der auszuhärtenden Querschnittsfläche identifiziert und selektiert werden. Erfindungsgemäß kann sehr effizient ein auf eine bestimmte, durch deren Umrisse definierte Querschnittsfläche des dreidimensionalen Objektes bezogener Energieeintrag beeinflußt werden. Am zweckmäßigsten wird innerhalb einer Querschnittsfläche, die durch eine erste Bitmap definiert wird, eine zweite Bitmap - oder weitere Bitmaps - erzeugt, wobei erste und zweite (und ggf. weitere) Bitmaps durch Mehrfachbelichtung überlagert werden. Die zweite Bitmap und die ggf. weiteren Bitmaps bilden dann jeweils Teilmasken innerhalb einer durch die erste Bitmap gebildeten Gesamtmaske. Die Ausdrücke ,,Teilmaske" und ,,innerhalb der Gesamtmaske" bedeuten jeweils erfindungsgemäß typischerweise, daß verglichen mit der Gesamtmaske, bezogen auf die gleiche oder eine kleinere Querschnittsfläche davon, eine kleinere oder mehrere kleinere Fläche(n) belichtet werden. Zweite und ggf. weitere Bitmaps brauchen nicht gleich sein, sondern können je nach Wunsch innerhalb der Gesamtmaske der ersten Bitmap variiert werden. Somit können die neben der Gesamtmaske gebildeten Teilmasken identisch oder verschieden sein, oder es können unterschiedliche Unter-Teilmasken gebildet werden. Erfindungsgemäß kann eine VOXEL-Matrix generiert werden durch Mehrfachbelichtung innerhalb einer vorbestimmten, definierten Gesamtbildfläche der Bauebene. Ein Versetzen von Bildern in der Bauebene pro generierter Querschnittsfläche ist vorteilhaft entbehrlich. Durch eine Voxel-Matrixbildung können z.B. eine Stützstruktur, Überhänge und/oder besonders kleine/filigrane Bereiche wesentlich feiner und präziser gebildet werden.
Die Reihenfolge der Verwendung der Gesamtmaske und der Teilmaske(n) ist beliebig wählbar, d.h. "erste", "zweite" und "weitere" Bitmaps legt keine zeitliche Abfolge fest, sondern bezeichnet lediglich unterschiedliche Bitmaps der multiplen Maskenbelichtung. Zweckmäßiger Weise wird jedoch die erste Bitmap mit der Gesamtmaske zuerst verwendet. Die jeweiligen Bitmaps können über entsprechende Software-Algorithmen generiert werden. Die Belichtungszeiten pro Gesamtmaske und pro Teilmaske können zusätzlich unabhängig voneinander durch einen elektromechanischen Verschluß gesteuert werden.
Mittels der erfindungsgemäßen multiplen Maskenbelichtung kann so die Durchhärtetiefe eines jeden Voxels pixelgenau gesteuert werden, sodass insgesamt die Qualität des Bauteils bzgl. Oberflächengüte, Grünlingshärte, Detailtreue und Toleranzen verbessert und auch die Beschaffenheit der notwendigen Stützstrukturen optimiert werden.

Die erfindungsgemäße multiple Maskenbelichtung erlaubt außerdem eine "Überbelichtung" in selektierten Bereichen der auszuhärtenden Voxel-Matrix, die über eine reine Grauwert-Abstufung innerhalb der Bitmap nicht möglich wäre, da durch eine Grauwert-Anpassung grundsätzlich Strahlungs- bzw. Lichtenergie zumindest teilweise gelöscht wird, was grundsätzlich unerwünscht ist. Dennoch kann es zur weiteren Feinabstimmung von besonderem Vorteil sein, innerhalb der ersten, der zweiten und/oder der weiteren Bitmaps Grauwert- und/oder Farbwerteinstellungen vorzunehmen. Dadurch kann eine weitere Feinabstimmung erreicht werden, während gleichzeitig die Anzahl der Bitmaps innerhalb der Gesamtmaske begrenzt wird, die ohne Grauwert- und/oder Farbwerteinstellung zum Erreichen einer gleichen Feinabstimmung notwendig wäre. Die Grauwert- und/oder Farbwerteinstellung kann pixel-spezifisch bei einzelnen oder einem Teil der Pixel pro Bitmap bzw. Teilbitmap erfolgen.
Durch eine geschickte Auswahl und Abfolge von Masken zur Teilbelichtung innerhalb eines Belichtungszyklus pro Querschnittsfläche können besondere Belichtungsstrategien z.B. zur Aushärtung von Überhängen, Überbelichtung filigraner Strukturen und Materialanhäufungen, Reduzierung von Materialschrumpf innerhalb einer Bauebene etc. umgesetzt werden.
Die Erzeugung der zusätzlichen Belichtungsmasken wird vorzugsweise vollständig software-technisch gelöst und ist somit sehr flexibel und für alle auf SML-Technologie basierende Maskenprojektionssysteme einsetzbar.

Durch eine zusätzliche Grauwert- und/oder Farbkanal-Codierung der Bitmap auf Pixel-Ebene können gemäß einer speziellen Ausführungsform der Erfindung zusätzliche Parameter gespeichert und eingesetzt werden, die die Durchhärtetiefe des Voxels im aushärtbaren Material beeinflussen; hierzu gehört die Beeinflussung
a) der Strahlungs- bzw. Lichtintensität durch den Helligkeitswert (Grauwerte von weiss=255 bis schwarz=0) und
b) des Spektrums (Initiator- und Absorptions-Verhalten) durch die Farbinformation.

Durch die Grauwert- und/oder Farbkanalkodierung eines einzelnen Pixels ist es möglich, innerhalb der Bitmap eine Feinkorrektur der Belichtungsparameter vorzunehmen.
Einen zusätzlichen Steuerparameter bietet eine individuelle Belichtungszeit pro Bitmap, die durch einen Verschluss geregelt werden kann. Erst, wenn das digitale Bild von der bildgebenden Einheit vollständig aufgebaut worden ist, wird der Verschluss geöffnet und anschließend wieder geschlossen.
Das erfindungsgemäße Prinzip hinsichtlich Vorrichtung und Verfahren ist auf verschiedentliche Arten des Aufbaus des dreidimensionalen Objekts anwendbar. Der Aufbau des dreidimensionalen Objekts kann schichtweise, alternativ jedoch auch schichtenunabhängig erfolgen. Weitere Ausgestaltungsmöglichkeiten sind möglich. Zum Beispiel kann der Härtungsprozeß kontinuierlich ohne Schichten; diskontinuierlich (mit gleichen, verschiedenen oder variablen Schichtdicken); teilweise kontinuierlich und teilweise diskontinuierlich (diskontinuierlich mit gleichen, verschiedenen oder variablen Schichtdicken); oder in einer Kombination verschiedener Möglichkeiten erfolgen. Die Vorrichtung und das Verfahren gemäß der vorliegenden Erfindung ist besonders geeignet zum Erstellen eines dreidimensionalen Objekts in einer Voxel-Matrix unabhängig von Schichten.
Ferner kann die Verwendung mehrerer Bitmaps, oder die Anwendung einer ersten und einer zweiten bzw. von weiteren gerasterten Masken pro Querschnittsfläche gemäß der Erfindung für eine oder mehrere Querschnittsfläche(n) des zu erzeugenden dreidimensionalen Objekts angewandt werden.

### Ausführungsformen und Anwendungsbeispiele

Die Erfindung wird nachfolgen anhand von Ausführungsformen und Anwendungsbeispielen unter Bezugnahme auf Zeichnungen näher beschrieben, wobei die Beschreibung und die Darstellung der Zeichnungen nur beispielhaft sind und keinesfalls einschränkend zu verstehen sind, wobei:

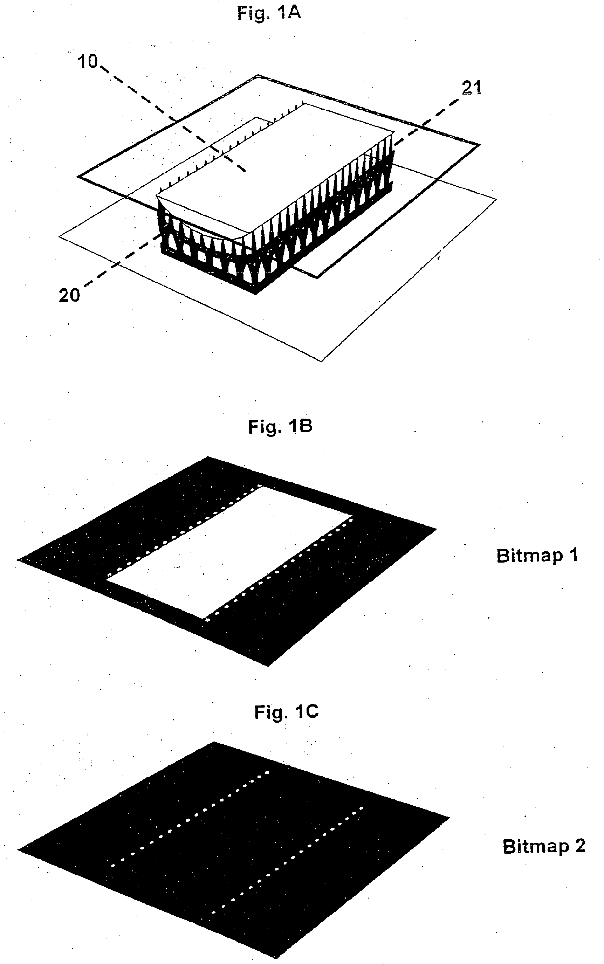

Fig. 1A bis 1C zeigen schematisch ein Beispiel des erfindungsgemäßen Prinzips durch Verwendung von auf eine Querschnittsfläche bezogenen mehreren Bitmaps, wobei Fig. 1A beispielhaft eine zu erzeugende Stützstruktur veranschaulicht und Fig. 1B und 1C die zu verwendenden Bitmaps 1 und 2, die zur Erzeugung von Stützstrukturen hilfreich sind;

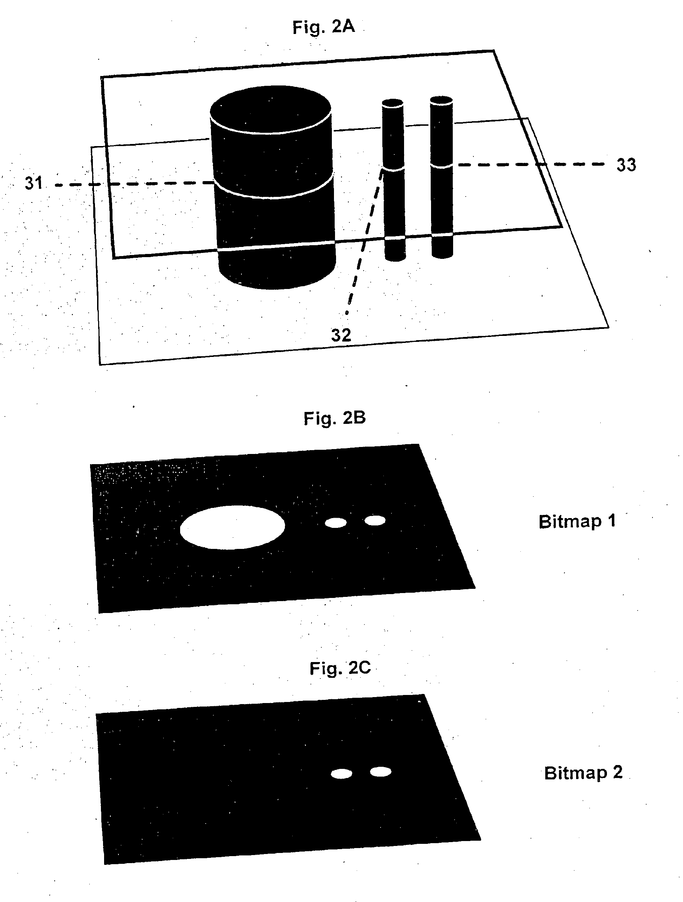

Fig. 2A bis 2C zeigen schematisch ein Beispiel des erfindungsgemäßen Prinzips durch Verwendung von auf eine Querschnittsfläche bezogenen mehreren Bitmaps, wobei Fig. 2A beispielhaft eine zu erzeugende Struktur mit großflächiger Querschnittsstruktur und filigranen Querschnittsstrukturen veranschaulicht und Fig. 2B und 2C die zu verwendenden Bitmaps 1 und 2 pro Querschnittsfläche zeigen;

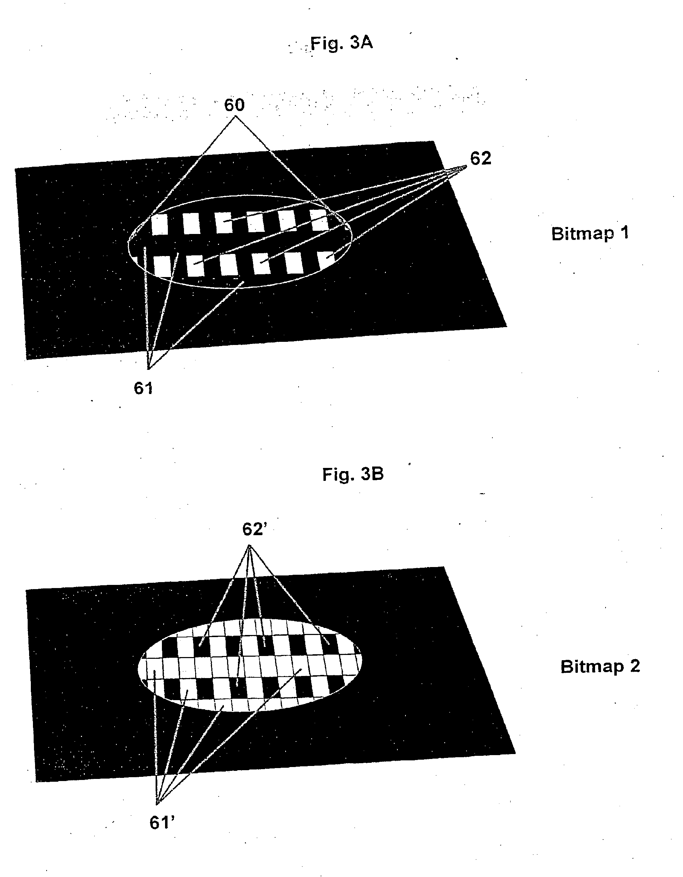

Fig. 3A und 3B veranschaulichen schematisch eine Grundidee gemäß einer weiteren Ausführungsform der vorliegenden Erfindung, bei der eine vorbestimmte Querschnittsfläche durch aufeinander folgende Bitmap-Muster, einschließlich einem Bitmap 1-Muster (Fig. 3A) und einem Bitmap 2-Muster (Fig. 3B), in Teilschritten bestrahlt wird;

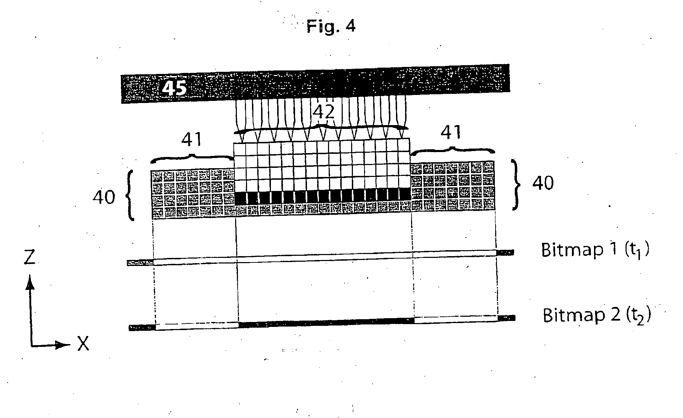

Fig. 4 zeigt schematisch ein vorteilhaftes Anwendungsbeispiel der Erfindung zur Stabilisierung von Überhängen; und

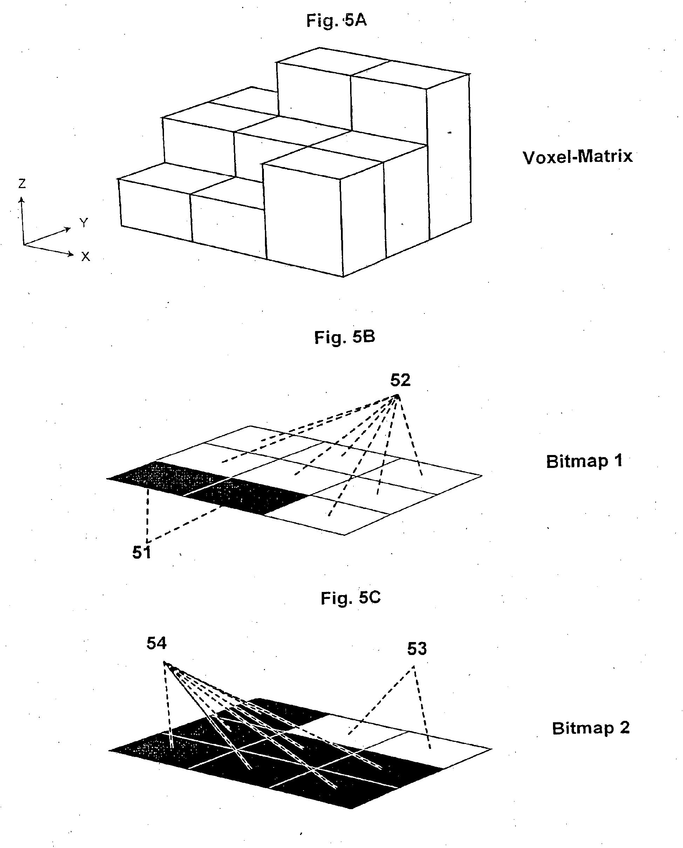

Fig. 5A bis 5C zeigen ein weiteres vorteilhaftes Anwendungsbeispiel zur Bildung komplexer Voxel-Matrices (Fig. 5A) unter Verwendung mehrere Bitmaps einschließlich einer Bitmap 1 (Fig. 5B) und einer Bitmap 2 (Fig. 5C) pro X,Y-Querschnittsfläche, um verschiedene Durchhärtetiefen in Z-Richtung für die Voxel-Matrix zu erhalten.

### Überbelichtung von Stützstrukturen

Wie in Fig. 1A schematisch veranschaulicht besteht ein wichtiges Ziel darin, Stützstrukturen 20 im Allgemeinen und insbesondere deren Kontaktpunkte 21 zum Bauteil 10 zu minimieren. Dies kann erfolgen, indem die Stützstruktur 20 während des Bauprozesses eine höhere Eigenfestigkeit durch einen höheren Polymerisationsgrad erlangt, was wiederum durch eine Überbelichtung durch Anwendung des erfindungsgemäßen Konzepts erreicht werden kann.
Aufgrund der Datenstruktur ist es möglich, für jeweilige Querschnittsflächen innerhalb des gesamten Bauteils (in Fig. 1 A schematisch perspektivisch angedeutet durch die obere Querschnittsfläche) Stützstrukturdaten von Bauteildaten zu unterscheiden und somit nur für die Bitmap-Bereiche der Stützstrukturen 20 und/oder selektiv für die Kontaktpunkte 21 eine zusätzliche, innerhalb der (die gesamte Querschnittsfläche abdeckenden) Gesamt-Bitmap 1 eine TeilBitmap 2 zu generieren, die der ersten Bitmap 1 mit einer definierten, d.h. im Verhältnis zur ersten Maskenbelichtung gleichen oder verschiedenen Belichtungszeit nachgeschaltet wird und diese überlagert, um somit eine Über-/Nach-Belichtung nur im Bereich der Stützstrukturen zu erreichen (Fig. 1B und 1C) .

### Durchhärtungstiefe bei großflächigen versus filigranen Querschnittsstrukturen / Überbelichtung von filigranen Strukturen

Bei großflächigeren Strukturen steht mehr Lichtleistung pro Fläche zur Verfügung als bei filigranen Strukturen; dieses Phänomen führt zu unterschiedlichen Aushärtung in xy-Ausdehnung (über die Kontur hinaus) und z-Ausdehnung (Tiefe) pro Querschnittsfläche.
Wird z.B. eine 10 mm x 10 mm große Fläche einmalig belichtet, so härtet sie z.B. 130 µm dick aus; eine Struktur von 2 mm x 10 mm härtet bei der selben Belichtungszeit dagegen nur 100 µm aus. Wird das Bauteil nun z.B. in Schichten ä 100 µm gebaut, so kann es passieren, dass in dem filigranen Bereich die generierten Schichten keine ausreichende chemische Verbindung durch Überbelichtung (130 µm Tiefenhärtung zu 30% in die vorhergehende Schicht hinein) miteinander eingehen, die Schichten in diesem Bereich separiert werden und das Bauteil defekt ist. Dieses Phänomen ist besonders kritisch bei filigranen Stützstrukturen.
Fig. 2A zeigt schematisch ein Beispiel mit großflächiger Querschnittsstruktur 31 und filigranen Querschnittsstrukturen 32,33. Die gesamte Querschnittsfläche für das zur generierende Bauteil ist in Fig. 2A schematisch perspektivisch angedeutet durch die obere Querschnittsfläche. Durch geeignete Algorithmen werden in dem Querschnittsbild die Strukturen unterschiedlicher Flächenausdehnung 31 bzw. 32 und 33 identifiziert und ein oder mehrere, entsprechende TeilBitmap(s) 2, die innerhalb der (die gesamte Querschnittsfläche abdeckenden) Gesamt-Bitmap 1 liegen und letzteres überlagern, zur Nachbelichtung der filigranen Strukturen generiert und mit entsprechender Belichtungszeit versehen. Die Gliederungstiefe der Teil-Bitmaps bleibt dabei dem Anwender überlassen.
Zusätzlich können größer flächige Querschnittsstrukturen 31 mit passenden Grauwerten pixelgenau belegt werden, während kleiner flächige Querschnittsstrukturen 32,33 pixelgenau mit geringeren Grauwerten oder ohne Grauwert (d.h. weiß) belegt werden, um eine noch gleichmäßigere Durchhärtetiefe (Z) und -Ausdehnung (XY) über die gesamte zu belichtende Flächenstruktur zu erhalten. Das heißt größere Flächenstrukturen werden dabei entsprechend ihrer Ausdehnung abgedunkelt.

### Höhere Grünlingshärte bzw. Überbelichtgung bei massiven Strukturen oder höheren Materialansammlungen innerhalb eines Bauteils

Bei manchen Bauteilen ergeben sich Volumenbereiche mit einer Anhäufung von Material, deren Wandstärke zum einen die maximal mögliche Durchhärtetiefe des Materials bei der Nachhärtung überschreitet , oder die sich an einer Position innerhalb des Bauteils befinden, die im Nachhärteprozess nicht oder nur eingeschränkt von der Lichtenergie erreicht werden.
Solche Volumenbereiche können schon während des Generierungsprozesses eine höhere Grünlingshärte erreichen, indem sie gezielt überbelichtet werden. Dies kann durch Mehrfach-Belichtung pro Querschnittsfläche erfolgen. Alternativ oder zusätzlich kann dies auch durch entsprechende Grauwertbelegung nachfolgender Querschnittsflächen erfolgen,
wobei im letzteren Fall die Durchhärtetiefe in Z die aktuelle Verfestigung um ein Vielfaches übersteigen sollte. Ferner können die Belichtungszeiten für die zur Nach-/Überbelichtgung des selektierten Bereichs verwendeten Teil-Bitmaps in Abhängigkeit der gewünschten Durchhärtetiefe sukzessive erhöht werden.

### Belichtungsstrategie zur Reduzierung von Schrumpf nicht Teil der Erfindung

Die in Fig. 3A und 3B schematisch veranschaulichte Grundidee ist hier, dass eine vorbestimmte auszuhärtende Querschnittsfläche (hier dargestellt durch die Fläche 60) nicht auf einmal in Gänze belichtet und ausgehärtet wird, sondern durch sich ergänzende, aufeinander folgende Bitmap-Muster, einschließlich einem Bitmap 1-Muster und einem Bitmap 2-Muster in Teilschritten belichtet und gehärtet wird (Fig. 3A und 3B). Wie in Fig. 3A gezeigt weist das Bitmap-Muster 1 in den bestrahlten Flächen besonders geeignet eine Matrix von in Reihen und Spalten angeordneten, zu bestrahlenden Quadraten bzw. Teilquadraten 62 auf (ein Gittermuster 61 bleibt unbelichtet), während über das Bitmap-Muster 2 gemäß Fig. 3B die zuvor nicht bestrahlten Lücken (d.h. ein Gittermuster 61') im zweiten Schritt bestrahlt werden (hier bleiben nun die den Quadraten bzw. Teilquadraten 62 entsprechenden Quadrate bzw. Teilquadrate 62' unbestrahlt). Dadurch wird dem Material die Möglichkeit gegeben, nach der ersten Teilaushärtung mittels erstem Bitmap-Muster 1 in die durch den Materialschrumpf entstandenen "Zwischenräume" nachzufließen, um dann durch das ergänzende Bitmap-Muster 2 ausgehärtet zu werden. Die jeweiligen Bitmap-Muster sind nicht auf die hier gezeigten beschränkt. Auch können Überlappungen von bestrahlten Flächen der Bitmap-Muster vorgesehen sein.

### Belichtungsstrategie für Überhänge

Fig. 4 zeigt schematisch ein vorteilhaftes Anwendungsbeispiel zur Stabilisierung von Überhängen.
Um bei Überhängen 41 für eine bestimmte Teilstruktur 40 mit jeweiligen Bauebenen eine stabilere Verfestigung im Bereich des Überhanges generieren zu können, werden zunächst in dem Überhangbereich z.B. die ersten 3 Bauebenen bei den Belichtungszyklen ausgespart, so daß nur im Hauptbauteilbereich 42 entsprechende Verfestigungen erfolgen. Danach wird der Überhangsbereich 41 erst mit dem vierten Belichtungszyklus mit mehrfacher Energie belichtet. Erfindungsgemäß wird dazu bei dem vierten Belichtgungszyklus zuerst mit einer die Gesamtbelichtungsfläche (d.h. Hauptbauteilbereich 40 und Überhangsbereiche 41 links und rechts davon) belichtenden Bitmap 1 mit einer vorbestimmten Belichtungszeit t₁ belichtet, und dann wird mit einer TeilBitmap 2, die nur die Überhangsbereiche 41 links und rechts abdeckt, mit einer längeren Belichtungszeit t₂, z.B. der 4-5 fachen Belichtungszeit im Vergleich zur Belichtungszeit t₁ der Bitmap 1, nachbelichtet (s. Fig. 4). Bezugszeichen 45 zeigt eine Trägerplatte.

### Bildung komplexer Voxel-Matrices durch Kombination von multipler Maskenbelichtung und Grauwert- und/oder Farbwerteinstellung

Ein weiteres vorteilhaftes Anwendungsbeispiel durch Bildung komplexer Voxel-Matrices wird anhand der Fig. 5A bis 5C gezeigt. Dies wird schematisch nur an einem kleinen Teilbereich von 3x3 Pixeln erläutert, jedoch ist klar, daß dasselbe Prinzip auch auf andere, insbesondere größere Flächen mit mehr Pixeln anwendbar ist. Um die in Fig. 5A gezeigte Voxel-Matrix mit drei verschiedenen Durchhärtetiefen zu erhalten wird auf die Querschnittsfläche bezogen, die durch x und y definiert ist, zunächst eine erste Belichtung durch eine mit einer ersten Bitmap 1 generierten Maske durchgeführt, wobei den zwei Pixeln für die geringste Durchhärtetiefe (in der Figur vorne links mit Bezugszeichen 51 angedeutet) zusätzlich Grauwerte zugeordnet werden und den übrigen Pixel weiß zugeordnet wird (kein Grauwert; in der Figur mit Bezugszeichen 52 angedeutet). Dann wird, bezogen auf die gleiche durch x und y definierte Querschnittsfläche, eine zweite Belichtung durch eine mit einer zweiten Bitmap 2 generierten Teilmaske durchgeführt, wobei den zwei Pixeln für die höchste Durchhärtetiefe weiß zugeordnet wird (kein Grauwert; in der Figur hinten rechts mit Bezugszeichen 53 angedeutet), während die übrigen Pixel völlig abgedunkelt werden (schwarz; in der Figur mit Bezugszeichen 54 angedeutet).
Als Ergebnis wird eine komplexe Voxel-Matrix mit nur zwei Belichtungsschritten pro Querschnittsflächen erhalten.

Für alle oben beschriebenen Anwendungen ist eine Feinabstufung innerhalb der Teil-Bitmaps durch pixelgenaue Farbkanal-Codierung möglich, d.h. die Bitmap-Maske / Belichtungsmaske kann pro Pixel zusätzlich Schwarz/Weiß-, Grauwert- und/oder Farbinformationen enthalten, durch die die Belichtungsintensität innerhalb der Bitmap pixelgenau gesteuert wird. Außerdem können bei allen Anwendungen die Belichtungszeiten pro Bitmap unabhängig voneinander eingestellt werden, so daß ein zusätzlicher Parameter für die selektive Durchhärtetiefe der Voxel-Matrix bereitgestellt wird.

Bei der Reihenfolge und der Gestaltung der Belichtungsmuster pro Gesamt-Maske und Teil-Maske der erfindungsgemäßen Mehrfachbelichtung sind keine Grenzen gesetzt. Es sollte nur darauf geachtet werden, dass durch jede Teil-Bestrahlung bzw. -Belichtung mindestens eine Energie erreicht wird, die notwendig ist, um das Material anzuhärten oder auszuhärten.

Die beschriebenen Anwendungsbeispiele können beliebig miteinander kombiniert werden. Sie sind ferner nur beispielhaft und sind keinesfalls einschränkend zu verstehen. Vielmehr können sie ohne weiteres modifiziert werden, um das erfindungsgemäße Prinzip durch andere Ausführungsformen zu realisieren.

## Patentansprüche

1. Vorrichtung zur Herstellung eines dreidimensionalen Objektes durch Verfestigen eines verfestigbaren Materials unter Einwirkung von elektromagnetischer Strahlung mittels Energieeintrag über eine gerasterte bildgebende Einheit, die eine bestimmte Anzahl diskreter, als Punkt, als Zeile oder als Matrix angeordneter bildgebender Elemente oder Pixel aufweist, wobei die bildgebende Einheit ein auf eine bestimmte Querschnittsfläche des dreidimensionalen Objektes bezogenes Bild aus den Pixeln projiziert und eine gerasterte Maske oder Bitmap bildet, **dadurch gekennzeichnet, dass** die bildgebende Einheit so angesteuert wird, daß mindestens zwei Masken oder Bitmaps generiert werden mit:
einer die Querschnittsfläche abdeckenden ersten Gesamtmaske oder Bitmap 1, und
einer Teilmaske oder Bitmap 2 innerhalb der Gesamtmaske oder Bitmap 1,
und daß ferner mindestens eine der Masken oder Bitmaps pro Bildpunkt oder Pixel in Bezug auf Grauwert und/oder Farbwert ansteuerbar ist.

2. Vorrichtung nach Anspruch 1, **dadurch gekennzeichnet, daß** die Steuerung des Energieeintrags eine Matrix aus Volumenelementen generiert,
und/oder daß die Durchhärtetiefe je Volumenelementen im verfestigbaren Material durch Liefern von Lichtintensität und/der selektierter Lichtwellenlänge veränderbar ist.

3. Vorrichtung nach Anspruch 1 oder 2, **dadurch gekennzeichnet, daß** daß mindestens einem Teil der Pixel zum variablen Energieeintrag mehr als zwei Energiestufen zugeordnet werden können, wobei die mehr als zwei Energiestufen einschließen:
a) AN- und AUS-Zustände und
b1) eine bestimmte Zahl von Graustufen oder
b2) eine bestimmte Zahl von Farbwerten.

4. Vorrichtung nach einem der Ansprüche 1 bis 3, **dadurch gekennzeichnet, dass** die bildgebende Einheit in einer Projektionseinheit eingeschlossen ist.

5. Vorrichtung nach einem der Ansprüche 1 bis 3, **dadurch gekennzeichnet, dass** die bildgebende Einheit vom Typ eines Spatial Light Modulator ist.

6. Vorrichtung nach einem der Ansprüche 1 bis 3, **dadurch gekennzeichnet, dass** es sich bei der bildgebenden Einheit um einen emittierenden Punkt, eine emittierende Zeile oder eine emmitierende Matrix, umfassend Light-Valves in MEMS-Technologie, handelt.

7. Vorrichtung nach einem der Ansprüche 1 bis 3, **dadurch gekennzeichnet, dass** es sich bei der bildgebenden Einheit um einen emittierenden Punkt, eine emittierende Zeile oder eine emmitierende Matrix, mit jeweils eingeschlossenen LED's, handelt.

8. Vorrichtung nach einem der Ansprüche 1 bis 7, **dadurch gekennzeichnet, dass** ein zusätzlicher Verschluss zwischen auszuhärtendem Material und Energiequelle angeordnet ist, zur Steuerung der Belichtungszeit pro Maske.

9. Vorrichtung nach einem der Ansprüche 1 bis 8, **dadurch gekennzeichnet, dass** die Belichtung mittels mehrerer aufeinander folgender gerasterter Masken oder Bitmaps pro Bauebene erfolgt.

10. Verfahren zur Herstellung eines dreidimensionalen Objektes durch Verfestigen eines, unter Einwirkung von elektromagnetischer Strahlung verfestigbaren Materials mittels Energieeintrag über eine bildgebende Einheit, die eine bestimmte Anzahl diskreter bildgebender Elemente oder Pixel aufweist, wobei die bildgebende Einheit ein auf eine bestimmte Querschnittsfläche des dreidimensionalen Objekts bezogenes Bild aus den Pixeln projiziert und eine gerasterte Maske oder Bitmap bildet, **dadurch gekennzeichnet, dass** bezogen auf mindestens eine Querschnittsfläche des dreidimensionalen Objekts mindestens zwei Masken oder Bitmaps verwendet werden mit:
einer die Querschnittsfläche abdeckenden ersten Gesamtmaske oder Bitmap 1, und
einer Teilmaske oder Bitmap 2 innerhalb der Gesamtmaske oder Bitmap 1, und
dass Informationen bezüglich Grauwert und/oder und Farbwert in dem gerasterten Bild oder der Bitmap pro Bildpunkt oder Pixel gespeichert werden.

11. Verfahren nach Anspruch 10, **dadurch gekennzeichnet, dass** zur Verfestigung des Materials das Bild mittels einer Projektionseinheit in die Bauebene projiziert wird.

12. Verfahren nach einem der Ansprüche10 oder 11, **dadurch gekennzeichnet, dass** pro bestimmter Querschnittsfläche des dreidimensionalen Objekts ermittelt wird, welche Bereiche in der auszuhärtenden Matrix aus Volumenelementen entweder nicht belichtet oder zusätzlich belichtet werden sollen und aus dieser Information entsprechende Teil-Bitmaps generiert und zur Belichtung eingesetzt werden.

13. Verfahren nach einem der Ansprüche 10 bis 12, **dadurch gekennzeichnet, dass** in einem pro bestimmter Querschnittsfläche des dreidimensionalen Objekts erzeugten Querschnittsbild getrennte Bereiche unterschiedlicher Flächenausdehnung identifiziert werden und für Bereiche mit kleinerer Ausdehnung eine oder mehrere zusätzliche Bitmaps entsprechend der Struktur der kleineren Flächenausdehnung erzeugt und zu einer nachfolgenden Teilbelichtung eingesetzt werden.

14. Verfahren nach einem der Ansprüche 10 bis 13, **dadurch gekennzeichnet, dass** bestimmte Strukturen innerhalb des Bauteils identifiziert werden, für deren Querschnittsflächen zusätzliche Bitmaps zwecks Mehrfachbelichtung pro Querschnittsfläche erzeugt werden.

15. Verfahren nach einem der Ansprüche 10 bis 14, **dadurch gekennzeichnet, dass** eine erhöhte Aushärtung selektierter Flächenbereiche durch Ein- oder Mehrfach-Belichtung erfolgt, indem pro Querschnittsfläche eine oder mehrere Masken oder Bitmaps mit unterschiedlichen Informationen erzeugt und damit in Folge belichtet wird, wobei die erreichte Durchärtetiefe der Volumenelemente in Bereichen einer Mehrfachbelichtung die Dicke der aktuellen Verfestigung um eine Vielfaches übersteigt.

16. Verfahren nach einem der Ansprüche 10 bis 15, **dadurch gekennzeichnet, dass** zur Steuerung der Belichtungszeit pro Maske oder Bitmap ein zusätzlicher Verschluss zwischen auszuhärtendem Material und Energiequelle verwendet wird.

17. Verfahren nach einem der Ansprüche 10 bis 16, **dadurch gekennzeichnet, dass** Informationen bezüglich Grauwert und/oder Farbwert pro Bildpunkt oder Pixel online für jedes gerasterte Bild oder jede Bitmap aktuell berechnet werden.

18. Verfahren nach einem der Ansprüche 10 bis 17, **dadurch gekennzeichnet, dass** die Belichtung mittels mehrerer aufeinander folgender gerasterter Masken oder Bitmaps pro Bauebene erfolgt.

## Claims

1. Device for producing a three-dimensional object by solidifying a solidifiable material under the effect of electromagnetic radiation by energy input via a rasterized imaging unit, which comprises a certain number of discrete imaging elements or pixels, arranged as point, as line or as matrix, wherein the imaging unit projects an image related to a certain cross-sectional area of the three-dimensional object from the pixels and forms a rasterized mask or bitmap, **characterized in that** the imaging unit is controlled in a manner, that at least two masks or bitmaps are generated with:
a first overall mask or bitmap 1 covering the cross-sectional area, and
a partial mask or bitmap 2 within the overall mask or bitmap 1,
and that further at least one of the masks or bitmaps is controllable per image point or pixel in relation to grey value or color value.

2. Device according to claim 1, **characterized in that** the control of the energy input generates a matrix of volume elements,
and/or that the hardening depth per volume element in the solidifiable material is variable by providing light intensity and/or selected light wavelength.

3. Device according to claims 1 or 2, **characterized in that** more than two energy levels can be attributed to at least a part of the pixels for variable energy input, wherein the more than two energy levels include:
a) ON- and OFF-states and
b1) a defined number of grey levels or
b2) a defined number of color values.

4. Device according to one of claims 1 to 3, **characterized in that** the imaging unit is included in a projection unit.

5. Device according to one of claims 1 to 3, **characterized in that** the imaging unit is of the type of a Spatial Light Modulator.

6. Device according to one of claims 1 to 3, **characterized in that** the imaging unit is an emitting point, an emitting line or an emitting matrix, comprising Light-Valves in MEMS-technology.

7. Device according to one of claims 1 to 3, **characterized in that** the imaging unit is an emitting point, an emitting line or an emitting matrix, with respectively included LEDs.

8. Device according to one of claims 1 to 7, **characterized in that** an additional shutter is disposed between the material to be hardened and energy source for the control of the exposure time per mask.

9. Device according to one of claims 1 to 8, **characterized in that** the exposure is performed via multiple sequential, rasterized masks or bitmaps per building plane.

10. Method for producing a three-dimensional object by solidifying of a material, which is solidifiable under the effect of electro-magnetic radiation by energy input via an imaging unit, which comprises a certain number of discrete image elements or pixels wherein the imaging unit projects an image related to a certain cross-sectional area of the three-dimensional object from the pixels and forms a rasterized mask or bitmap, **characterized in that**, related to at least one cross-sectional area of the three-dimensional object, at least two masks or bitmaps are used with:
a first overall mask or bitmap (1) covering the cross-sectional area, and
a partial mask or bitmap (2) within the overall mask or bitmap (1), and
that information relating to grey value and/or colour value in the rasterized image or the bitmap are saved per image point or pixel.

11. Method according to claim 10, **characterized in that** the image is projected via a projection unit in the building plane for solidifying of the material.

12. Method according to one of claims 10 or 11, **characterized in that** it is determined per defined cross-sectional area of the three-dimensional object which areas in the matrix of volume elements to be hardened shall either not be exposed or shall be additionally exposed, and from this information, corresponding partial bitmaps are generated and applied for exposure.

13. Method according to one of claims 10 or 11, **characterized in that** in a cross-sectional image produced per certain cross-sectional area of the three-dimensional object, separate areas of different area extension are identified, and for areas with a smaller extension, one or multiple additional bitmaps corresponding to the structure of the smaller area expansion is/are produced and used for subsequent partial exposure.

14. Method according to one of the claims 10 to 13, **characterized in that** specific structures within the object are identified for whose cross-sectional areas additional bitmaps are generated for the purpose of multiple exposure per cross-sectional area.

15. Method according to one of the claims 10 to 14, **characterized in that** an increased hardening of selected areas is carried out via single or multiple exposure, by generating and subsequently exposing with one or multiple masks or bitmaps having different information per cross-sectional area, wherein the achieved hardening depth of the volume elements in areas of a multiple exposure exceeds several-fold a thickness of a current solidification.

16. Method according to one claims 10 to 15, **characterized in that** an additional shutter is used between the material to be hardened and an energy source, for controlling the exposure time per mask or bitmap.

17. Method according to one of claims 10 to 16, **characterized in that** information in terms of a grey value and/or a colour value per image point or pixel is currently calculated online for each raster image or each bitmap.

18. Method according to one of claims 10 to 17, **characterized in that** the exposure is performed via multiple subsequent rasterized masks or bitmaps per building plane.

## Revendications

1. Dispositif pour la fabrication d'un objet tridimensionnel par solidification d'un matériau solidifiable sous l'effet d'un rayonnement électromagnétique par apport d'énergie au moyen d'une unité d'imagerie tramée présentant un nombre défini d'éléments d'imagerie discrets ou de pixels agencés sous forme de point, de ligne ou de matrice, ladite unité d'imagerie projetant à partir des pixels une image relative à une surface de section transversale définie de l'objet tridimensionnel et formant un masque ou un bitmap tramé, **caractérisé en ce que** l'unité d'imagerie est commandée de manière à générer au moins deux masques ou bitmaps avec :
un premier masque d'ensemble ou bitmap 1 couvrant la surface de section transversale, et
un masque partiel ou bitmap 2 à l'intérieur du masque d'ensemble ou bitmap 1,
et **en ce qu'**au moins un des masques ou bitmaps peut en outre être commandé par point d'image ou pixel quant à sa valeur de gris et/ou sa valeur colorimétrique.

2. Dispositif selon la revendication 1, **caractérisé en ce que** la commande de l'apport d'énergie génère une matrice d'éléments de volume,
et/ou **en ce que** la profondeur de durcissement par élément de volume dans le matériau solidifiable peut être modifiée par apport d'intensité lumineuse et/ou longueur d'onde lumineuse sélectionnée.

3. Dispositif selon la revendication 1 ou 2, **caractérisé en ce qu'**au moins une partie des pixels peut être affectée à plus de deux niveaux d'énergie pour un apport d'énergie variable, lesdits plus de deux niveaux d'énergie comprenant :
a) des états ON et OFF, et
b1) un nombre défini de niveaux de gris ou
b2) un nombre défini de valeurs colorimétriques.

4. Dispositif selon l'une des revendications 1 à 3, **caractérisé en ce que** l'unité d'imagerie est incluse dans une unité de projection.

5. Dispositif selon l'une des revendications 1 à 3, **caractérisé en ce que** l'unité d'imagerie est du type d'un modulateur spatial de lumière.

6. Dispositif selon l'une des revendications 1 à 3, **caractérisé en ce que** l'unité d'imagerie est un point émetteur, une ligne émettrice ou une matrice émettrice, comprenant des valves optiques de technologie MEMS.

7. Dispositif selon l'une des revendications 1 à 3, **caractérisé en ce que** l'unité d'imagerie est un point émetteur, une ligne émettrice ou une matrice émettrice avec des LED intégrées.

8. Dispositif selon l'une des revendications 1 à 7, **caractérisé en ce qu'**un obturateur complémentaire est disposé entre le matériau à durcir et la source d'énergie pour la commande du temps d'exposition par masque.

9. Dispositif selon l'une des revendications 1 à 8, **caractérisé en ce que** l'exposition est effectuée au moyen de plusieurs masques ou bitmaps tramés successifs par plan de construction.

10. Procédé de fabrication d'un objet tridimensionnel par solidification d'un matériau solidifiable sous l'effet d'un rayonnement électromagnétique par apport d'énergie au moyen d'une unité d'imagerie présentant un nombre défini d'éléments d'imagerie discrets ou de pixels, ladite unité d'imagerie projetant à partir des pixels une image relative à une surface de section transversale définie de l'objet tridimensionnel et formant un masque ou un bitmap tramé, **caractérisé en ce qu'**au moins deux masques ou bitmaps sont utilisés par rapport à au moins une surface de section transversale de l'objet tridimensionnel, avec :
un premier masque d'ensemble ou bitmap 1 couvrant la surface de section transversale, et
un masque partiel ou bitmap 2 à l'intérieur du masque d'ensemble ou bitmap 1, et
**en ce que** des informations sont mémorisées par point d'image ou pixel quant à la valeur de gris et/ou la valeur colorimétrique dans l'image tramée ou le bitmap.

11. Procédé selon la revendication 10, **caractérisé en ce que** pour la solidification du matériau, l'image est projetée sur le plan de construction au moyen d'une unité de projection.

12. Procédé selon la revendication 10 ou 11, **caractérisé en ce que**, par surface de section transversale définie de l'objet tridimensionnel, il est déterminé quelles zones dans la matrice à durcir d'éléments de volume soit n'ont pas à être exposées, soit ont à être additionnellement exposées, et des bitmaps partiels correspondants sont générés à partir de cette information et utilisés pour exposition.

13. Procédé selon l'une des revendications 10 à 12, **caractérisé en ce que** des zones séparées de diverses étendues surfaciques sont identifiées dans une image de section transversale générée par surface de section transversale définie de l'objet tridimensionnel, et **en ce qu'**un ou plusieurs bitmaps complémentaires sont générés pour des zones de moindre étendue surfacique en fonction de la structure de la moindre étendue surfacique, et utilisés pour une exposition partielle consécutive.

14. Procédé selon l'une des revendications 10 à 13, **caractérisé en ce que** des structures définies sont identifiées à l'intérieur de la pièce, des bitmaps complémentaires étant générés pour les surfaces de section transversale de celles-ci en vue d'une exposition multiple par surface de section transversale.

15. Procédé selon l'une des revendications 10 à 14, **caractérisé en ce qu'**un durcissement accru de zones surfaciques sélectionnées est obtenu par exposition simple ou multiple, **en ce qu'**un ou plusieurs masques ou bitmaps sont générés avec différentes informations par surface de section transversale, une exposition consécutive étant ensuite effectuée avec ceux-ci, la profondeur de durcissement atteinte pour les éléments de volume dans des zones d'exposition multiple étant plusieurs fois supérieure à l'épaisseur de la solidification actuelle.

16. Procédé selon l'une des revendications 10 à 15, **caractérisé en ce qu'**un obturateur complémentaire est utilisé entre le matériau à durcir et la source d'énergie pour la commande du temps d'exposition par masque ou bitmap.

17. Procédé selon l'une des revendications 10 à 16, **caractérisé en ce que** des informations actuelles sont calculées en ligne quant à la valeur de gris et/ou la valeur colorimétrique par point d'image ou pixel pour chaque image tramée ou chaque bitmap.

18. Procédé selon l'une des revendications 10 à 17, **caractérisé en ce que** l'exposition est réalisée au moyen de plusieurs masques tramés ou bitmaps successifs par plan de construction.
